Europäisches Patentamt

European Patent Office

Office européen des brevets

(19)

(11) Numéro de publication: **0 221 616**
**B1**

(12) FASCICULE DE BREVET EUROPEEN

(45) Date de publication du fascicule du brevet:
18.04.90

(51) Int. Cl.⁴: **H01L 33/00**, H01L 31/02

(21) Numéro de dépôt: **86201911.4**

(22) Date de dépôt: **03.11.86**

(54) Composant opto-électronique pour montage en surface et son procédé de fabrication.

(30) Priorité: **05.11.85 FR 8516374**

(43) Date de publication de la demande:
**13.05.87 Bulletin 87/20**

(45) Mention de la délivrance du brevet:
**18.04.90 Bulletin 90/16**

(84) Etats contractants désignés:
**DE FR GB IT NL**

(56) Documents cités:
**EP-A- 0 042 484**
**EP-A- 0 127 239**
**WO-A-80/01860**
**US-A- 3 290 539**
**US-A- 4 168 102**

**PATENTS ABSTRACTS OF JAPAN,**
**vol. 3, no. 40 (E-102), 6 avril 1979 & JP-A-54 18 692**

(73) Titulaire: **RTC-COMPELEC, 130, Avenue Ledru-Rollin, F-75011 Paris(FR)**
(84) Etats contractants désignés: **FR**

(73) Titulaire: **N.V. Philips' Gloeilampenfabrieken, Groenewoudseweg 1, NL-5621 BA Eindhoven(NL)**
(84) Etats contractants désignés: **DE GB IT NL**

(72) Inventeur: **Thillays, Jacques Claude, SOCIETE CIVILE S.P.I.D. 209, rue de l'Université, F-75007 Paris(FR)**
Inventeur: **Vallée, Jean-Claude-Ange Pierre, SOCIETE CIVILE S.P.I.D. 209, rue de l'Université, F-75007 Paris(FR)**

(74) Mandataire: **Jacquard, Philippe et al, SOCIETE CIVILE S.P.I.D. 209, rue de l'Université, F-75007 Paris(FR)**

ACTORUM AG

## Description

La présente invention se rapporte à un composant opto-électronique comportant un élément opto-électronique disposé au fond d'une première cavité ménagée dans un substrat semi-conducteur en Si fortement dopé d'un premier type de conductivité présentant des surfaces supérieure et inférieure orientées suivant le plan (100), la première cavité ayant sa surface revêtue d'une couche métallique de manière à la rendre réfléchissante et comportant quatre pans disposés selon des plans (111) inclinés par rapport à la surface supérieure à partir de laquelle elle s'étend en se rétrécissant jusqu'à un fond plat également revêtu par la couche métallique, alors que l'élément opto-électronique présente une première électrode d'une zone du premier type de conductivité, soudée dans ledit fond plat sur la couche métallique et une seconde électrode d'une zone du second type de conductivité, reliée électriquement à la surface supérieure du substrat.

Un tel composant est connu de la demande de brevet japonais JP-A-54-18692 publiée le 10 février 1979.

Le problème que s'est posé la Demanderesse est celui de réaliser à faible coût un composant opto-électronique pour montage en surface pourvu d'une cavité réfléchissante améliorant le rendement optique, ce qui implique que le matériau de base soit facilement disponible et relativement bon marché, et d'autre part que les composants soient fabriqués collectivement.

Or, le composant opto-électronique d'après la JP-A-54-18692 ne permet ni ne prévoit son montage en surface.

Un composant opto-électronique pour montage en surface est connu de la demande PCT publiée sous le numéro WO 83/00408 le 3 février 1983 au nom de Joachim SIEG. Dans celle-ci, un support en céramique ($Al_2O_3$) est pourvu d'une cavité au fond de laquelle est soudé un élément opto-électronique sur une de deux métallisations servant à le raccorder électriquement. Des traversées conductrices (trous métallisés) permettent de disposer les contacts électriques pour le montage en surface.

Ce composant présente, mise à part la médiocre conductivité thermique de l'alumine, l'inconvénient d'une réalisation relativement coûteuse en raison du prix du matériau de base, en l'occurrence la céramique, et de la difficulté de réalisation de la cavité. La cavité est en outre de forme générale rectangulaire et non réfléchisssante : elle n'apporte donc pas de contribution au rendement optique du composant.

Le problème que s'est posé la Demanderesse est celui de réaliser à faible coût un composant opto-électronique pour montage en surface pourvu d'une cavité réfléchissante améliorant le rendement optique, ce qui implique que le matériau de base soit facilement disponible et ralativement bon marché, et d'autre part que les composants soient fabriqués collectivement. L'invention se propose également d'utiliser un matériau meilleur conducteur thermique que la céramique.

L'idée de base de l'invention consiste à utiliser comme support un substrat en Si qui permet à l'aide des moyens technologiques bien maîtrisés de l'industrie des semi-conducteurs de réaliser collectivement les composants et d'obtenir ensuite les composants individuels par simple découpe, ce qui conduit à des coûts unitaires faibles. L'idée de base de l'invention ne se limite toutefois pas au simple choix d'un matériau et de sa technologie tous deux connus, mais se rapporte plus particulièrement à l'adaptation spécifique de cette technologie au cas d'espèce, à savoir la réalisation de la cavité réfléchissante de chaque composant dans son support et de l'interconnexion électrique permettant de rendre ce composant apte au montage en surface.

Le dispositif selon l'invention est ainsi caractérisé en ce que le composant comporte une deuxième cavité de dimensions inférieures à celle de la première et s'étendant depuis la surface inférieure du substrat jusqu'à une ouverture du fond plat, la première et la deuxième cavités présentant à leur surface une région du second type de conductivité opposé au premier, et en ce que, en vue du montage en surface du composant, la seconde électrode est réliée à la surface supérieure du substrat au moyen d'une première couche conductrice, alors que la surface inférieure du substrat présente une deuxième couche conductrice en contact électrique avec la région du second type de conductivité et une troisième couche conductrice en contact électrique avec le substrat.

L'obtention des quatre pans inclinés est facilement réalisable grâce à la technique connue du décapage préférentiel. D'autre part, la région du second type de conductivité a pour fonction de réaliser une isolation électrique entre les contacts électriques de polarités opposées par diode en inverse lorsque l'élément électro-luminescent est mis sous tension. Ceci impose à la polarité particulière choisie pour le raccordement de ses électrodes. La continuité électrique entre la zone du second type de conductivité de l'élément opto-électronique et la troisième couche conductrice est réalisée à travers le substrat à cet effet très dopé.

La deuxième couche conductrice est avantageusement disposée sur au moins une partie d'un prolongement, affleurant à la surface inférieure du substrat, de ladite région du second type de conductivité. La surface inférieure du substrat peut être alors revêtue d'une première couche isolante présentant une ouverture de prise de contact débouchant sur ledit prolongement, la deuxième couche conductrice s'étendant au moins sur ladite ouverture. La surface supérieure du substrat peut être avantageusement revêtue d'une deuxième couche isolante présentant au moins une fenêtre, la première couche conductrice s'étendant au moins sur ladite fenêtre de manière à réaliser ledit contact électrique avec la surface supérieure du substrat. Une dite fenêtre peut former une bande parallèle à un des côtés de la cavité réfléchissante de manière à améliorer le contact électrique réalisé à travers le substrat. Une pluralité de fenêtres, par exemple 2, peut être prévu. La première couche conductrice peut également s'étendre sur la deuxième couche isolante.

Selon un mode de réalisation préféré, la deuxième cavité présente également quatre pans disposés suivant des plans (111) inclinés par rapport à la surface inférieure du substrat à partir de laquelle elle s'étend en se rétrécissant jusqu'à l'ouverture du fond plat.

L'invention concerne également un procédé de fabrication d'un composant opto-électronique pour montage en surface présentant un élément opto-électronique disposé au fond d'une première cavité ménagée dans un support. Selon l'invention, le support est un substrat en Si fortement dopé d'un premier type de conductivité et présentant des faces supérieure et inférieure orientées suivant le plan (100) et ses étapes sont les suivantes :

a) dépôt d'une première et seconde couche isolante respectivement sur les faces inférieure et supérieure du substrat.

b) ouverture dans la seconde couche isolante d'au moins une première série de premières ouvertures suivant un premier réseau à deux dimensions présentant des pas donnés et correspondant auxdites premières cavités, et dans la première couche isolante d'au moins une deuxième série de deuxièmes ouvertures plus petites que les premières et à l'aplomb de celles-ci suivant un deuxième réseau à deux dimensions de mêmes pas que le premier et correspondant à des deuxièmes cavités.

c) réalisation des première et deuxième cavités par attaque sélective du substrat par une solution susceptible de creuser celui-ci selon des plans (111) inclinés par rapport au plan (100) des faces supérieure et inférieure jusqu'à ce que chaque deuxième cavité débouche par une ouverture d'un fond plat d'une première cavité.

d) réalisation à partir de la surface des première et deuxième cavités de régions du second type de conductivité opposé au premier

e) dépôt d'une métallisation comportant une couche métallique à la surface des premières cavités de manière à rendre celles-ci réfléchissantes, et une couche métallique en contact électrique avec la face supérieure du substrat, ainsi qu'une couche conductrice, notamment métallique sur la face inférieure du substrat présentant des premières portions dont chacune est en contact électrique avec une des régions du second type de conductivité et des deuxièmes portions dont chacune est en contact électrique avec le substrat au voisinage de chaque deuxième cavité

f) réalisation de composants élémentaires mettant en oeuvre une étape de soudure d'éléments opto-électroniques de telle sorte qu'ils présentent chacun une zone du premier type de conductivité disposée sur le fond plat d'une première cavité en contact électrique avec la couche métallique et une zone du second type de conductivité en contact électrique avec la couche métallique contactant la face supérieure du substrat, ainsi qu'une étape de découpe du substrat de manière à séparer des composants élémentaires dont chacun comporte une première et une deuxième cavité, un élément opto-électronique et au moins une partie des première et deuxième portions de la deuxième couche métallique formant contact électrique respectivement avec une région du deuxième type de conductivité et avec le substrat.

Lors de l'étape f, la soudure des éléments opto-électroniques a lieu de préférence avant l'étape de découpe du substrat. Le procédé comporte avantageusement avant l'étape b, une étape a' d'ouverture dans la seconde couche isolante d'une première série de fenêtres, de diffusion à travers celle-ci de prolongements des régions du second type de conductivité réalisées lors de l'étape d, puis de réalisation dans ladite première série de fenêtres d'une troisième couche isolante d'épaisseur plus faible que celle de la première couche isolante.

Le procédé comporte avantageusement entre l'étape a et l'étape b, une étape a" d'ouverture dans les première et deuxième couche isolantes respectivement d'une deuxième et une troisième série de fenêtres dites de contact et d'obturation de celle-ci par une quatrième couche isolante d'épaisseur plus faible que celle des deux premières.

Lorsque l'étape a' est mise en oeuvre, elle intervient avant l'étape a" et l'étape de réalisation des troisième et quatrième couches isolantes est commune.

Selon une variante, l'étape de dépôt des troisième et quatrième couches isolantes consiste à déposer par oxydation une couche de $SiO_2$, puis par nitruration, du nitrure de Si.

L'invention sera mieux comprise à la lecture de la description qui va suivre, donnée à titre d'exemple non limitatif, en liaison avec les dessins qui représentent :

- les figures 1a à 1h en coupe parallèlement à la direction X les étapes de fabrication d'un mode de réalisation préféré de l'invention
- les figures 2a et 2b, respectivement en vue de dessous et de dessus, un composant terminé selon l'invention, et la figure 3 un schéma électrique équivalent.

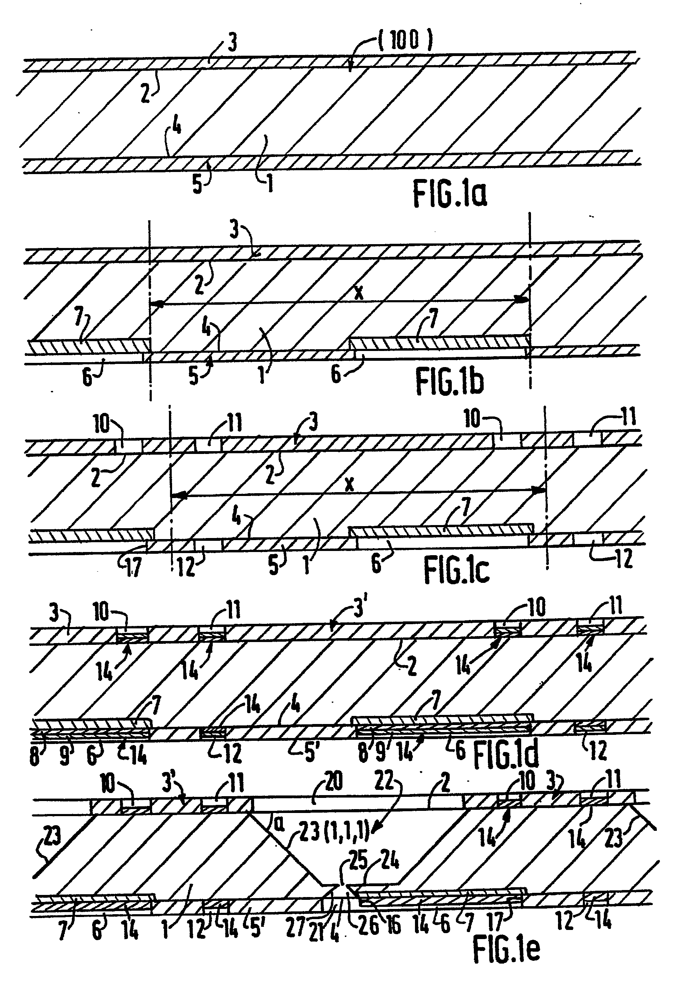

Selon la figure 1a, un substrat 1 fortement dopé d'un premier type de conductivité, par exemple du type p+ dopé à $5.10^{18}/cm^3$ et orienté suivant le plan (100) et d'une épaisseur de l'ordre de 0,4 mm est revêtu sur sa face supérieure 2 et sa face inférieure 4 d'une couche isolante, respectivement 3 et 5, comportant une couche d'oxyde d'environ 0,5 micron.

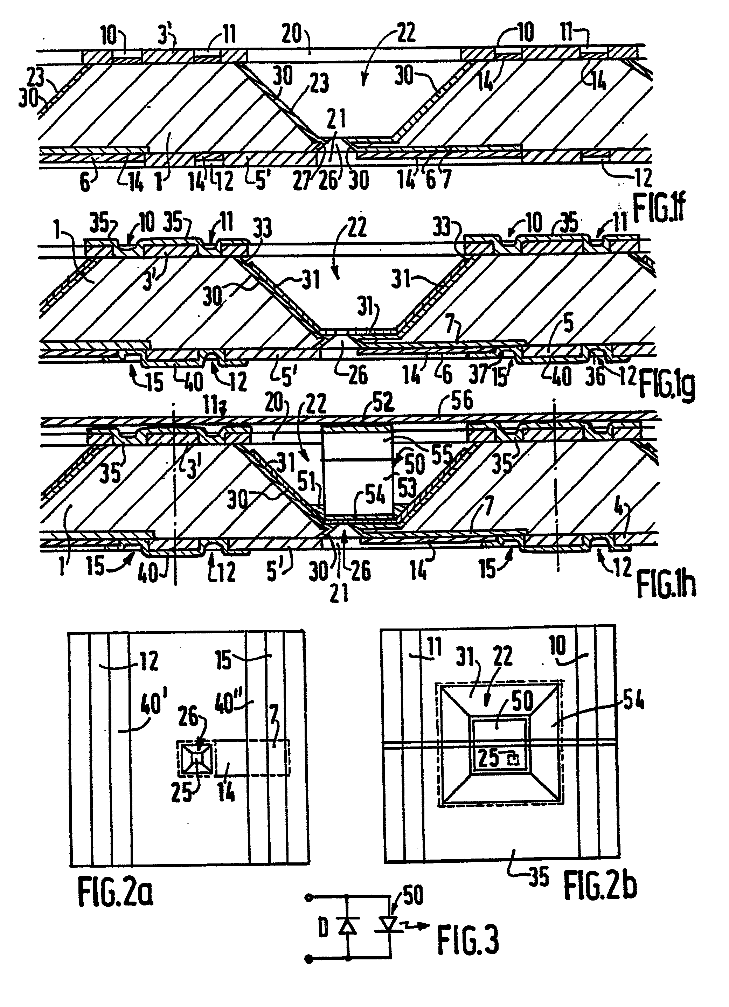

Selon la figure 1b, on réalise à travers la couche d'oxyde 5 un réseau à deux dimensions (X,Y) d'ouvertures rectangulaires allongées 6 (dont la forme est représentée selon un contour en pointillés à la figure 2a et que la coupe représente selon sa longueur) à travers lesquelles on diffuse des régions de contact 7 fortement dopées du deuxième type de conductivité, (par exemple du type n+ dopé à $5.10^{19}$ atomes/cm³).

Selon la figure 1c, on ouvre à travers la couche d'oxyde épais 3 deux séries de fenêtres de contact 10 et 11 formant des bandes dans la direction Y espacées d'un pas x. Les fenêtres de contact 10 ont été représentées avec un bord coplanaire avec les bords latéraux 17 des ouvertures 6. On réalise en même temps que les fenêtres 10 et 11, des fenêtres de contact 12 formant également des bandes dans la direction Y espacées d'un pas de préférence égal à x, mais cette fois à travers la couche d'oxyde 5. Les fenêtres de contact 12 ont été représentées à l'aplomb des fenêtres 11.

La trace des fenêtres 10 et 11 est visible à la figure 2b et celle des fenêtres 12 à la figure 2a.

Selon la figure 1d, on revêt les deux faces du substrat d'une couche isolante 14 comportant une fine couche d'oxyde (SiO$_2$) 8 d'épaisseur environ 0,1 micron revêtue d'une fine couche de nitrure de Si 9 d'épaisseur environ 0,1 micron de manière à obturer les fenêtres 10, 11 et 12 ainsi que les ouvertures 6. Pour la simplicité de la représentation, on n'a dessiné la couche 14 qu'à l'endroit desdites fenêtres et ouvertures, les couches 3 et 5 devenant 3' et 5' de manière à tenir compte de leur revêtement supplémentaire par les couches 8 et 9.

Selon la figure 1e, on ouvre dans la couche 3' des fenêtres carrées 20 et dans la couche 5' des fenêtres carrées 21 jouxtant les ouvertures 6. La longueur des côtés des carrés des fenêtres 20 est d'environ 0,6 mm et celle des côtés des carrés des fenêtres 21 d'environ 0,15 mm.

Les centres des fenêtres 20 et 21 ne sont de préférence pas situés à l'aplomb l'une de l'autre pour des raisons qui apparaîtront dans la suite de la description.

On réalise ensuite, par attaque d'une solution de potasse, les cavités 22 et 26. Ces cavités 22 et 26, du fait du caractère préférentiel de l'attaque, sont délimitées par des parois respectivement 23 et 27 disposées suivant des plans (111) formant un angle a = 54° par rapport respectivement aux faces 2 et 4. L'attaque est poursuivie jusqu'à ce que les cavités 22 et 26 se rejoignent au niveau d'ouvertures 25 d'un fond plat des cavités 22. Les ouvertures 25 sont avantageusement décalées latéralement dans les fonds plats correspondants 24 de manière à faciliter ultérieurement la mise en place des éléments opto-électroniques.

Selon la figure 1f, on diffuse dans les cavités 22 et 26 des régions 30 du deuxième type de conductivité par exemple de type n$^+$ fortement dopé à 10$^{19}$ atomes/cm$^3$. Du fait que les fenêtres 21 jouxtent les fenêtres 6, les régions 30 rejoignent les régions 7 de même type préalablement diffusées.

Selon la figure 1g, on enlève par décapage une partie des couches isolantes 14 de manière à laisser à nu le substrat à travers les fenêtres 10, 11 et 12 et à ouvrir des fenêtres 15 à l'extrémité des régions 7 opposée aux cavités 26. On réalise ensuite par pulvérisation une métallisation complète de la face supérieure du substrat de manière à obtenir en surface une couche métallique 35 recouvrant les parties subsistantes de la couche 3 et en contact avec le substrat 1 à travers les fenêtres 10 et 11 et à recouvrir les faces 23 et le fond 24 des cavités 22 d'une couche métallique 31. On remarquera que le léger sous-décapage qui s'est produit lors de l'attaque des cavités 22 par la solution de potasse a pour effet que la partie supérieure 33 de celles-ce n'est pas revêtu de métal, ce qui permet une isolation électrique entre les métallisations 31 et 35.

L'étape de pulvérisation comporte également la réalisation à travers un masque, de bandes métalliques 40 s'étendant d'une part sur les fenêtres 12 et 15, de manière à venir en contact avec le substrat 1, et d'autre part sur la portion de couche isolante 5 située entre celles-ci entre des cavités 22 adjacentes.

La figure 1h illustre les dernières étapes permettant d'arriver à des composants individuels. Les métallisations 54 des zones 53 du premier type de conductivité des diodes électroluminescentes 50 sont soudées collectivement par de la soudure 51 sur les métallisations 31 des fonds 24 des cavités 22. comme les centres des fenêtres 20 et 21 ne sont pas à l'aplomb l'une de l'autre, l'ouverture 25 est située dans un coin du fond plat 24, ce qui assure une bonne soudure de l'élément 50. La hauteur des cavités 22 est avantageusement choisie de manière que les diodes 50 aient leur métallisation supérieure 52, celle de leur zone 55 du deuxième type de conductivité, au même niveau que les métallisations 35. Ceci permet alors de souder un fil conducteur 56 à toutes les métallisations 35 et 52 d'une même rangée selon la direction X.

Les composants individuels sont alors obtenus par simple découpage parallèlement aux directions X et Y. La trace des plans de découpe parallèlement à la direction Y et espacés d'un pas x sont figurés en traits mixtes à la figure 1b. Chacune des bandes conductrices se divise en deux bandes 40' et 40". Après cette opération de découpe suivant deux directions, le composant est prêt à être utilisé.

La diode électroluminescente 50 présente une diode D connectée en parallèle et en inverse à ses bornes (fig. 3). Cette diode D est constituée par le substrat 1 du premier type de conductivité et par les diffusions 7 et 30 du deuxième type de conductivité.

En effet, la diode électroluminescente 50 a sa zone 53 du premier type de conductivité connectée à la métallisation 31 elle-même en contact électrique avec la diffusion 30 du deuxième type de conductivité et sa zone 55 du deuxième type de conductivité en contact électrique avec le substrat 1 du premier type de conductivité par l'intermédiaire de la métallisation 52 du fil 56 et de la métallisation 35 qui recouvre toute la face supérieure du composant.

Plus particulièrement aux figures 2a et 2b, le substrat 1 fortement dopé assure la continuité électrique entre la métallisation 35 connectée à la zone 55 et la métallisation 40' située à la face intérieure du composant et recouvrant la fenêtre 12. L'autre métallisation de la face inférieure du composant, à savoir la métallisation 40", qui recouvre la fenêtre 15 est en contact électrique avec la zone 53 par l'intermédiaire des zones diffusées 7 et 30. On remarquera que les métallisations 40' et 40" sont dans cette configuration disposées symétriquement par rapport à la diode 50, et le long des bords du composant, ce qui est favorable pour le montage en surface.

D'autre part, la présence d'une métallisation 31 sur la surface de la cavité 22 confère également à celle-ci des propriétés réfléchissantes lui permettant de renvoyer vers l'utilisateur la lumière émise par les faces latérales de la diode électroluminescente 50.

L'invention ne se limite pas au mode de réalisation récrit et représenté, lequel ne doit être considéré que comme un meilleur mode de mise en oeuvre de l'invention.

Par exemple, le fait de réaliser (fig. 1d) les fenêtres 6 en même temps que les fenêtres 11 et 12, a pour but de minimiser le nombre de ces opérations et également de bien aligner les fenêtres de deux faces les unes par rapport aux autres.

D'autre part, au niveau de la structure, on remarquera que la prise de contact de la zone 53 pourrait être réalisée sans mettre en oeuvre la diffusion supplémentaire 7 par exemple en réalisant après montage des diodes 50 une sérigraphie métallique épaisse au moins des ouvertures 26.

## Revendications

1. Composant opto-électronique comportant un élément opto-électronique (50) disposé au fond d'une première cavité (22) ménagée dans un substrat (1) semi-conducteur en Si fortement dopé d'un premier type de conductivité présentant des faces supérieure (2) et inférieure (4) orientées suivant le plan (100), la première cavité ayant sa surface revêtue d'une couche métallique (31) de manière à la rendre réfléchissante et comportant quatre pans disposés selon des plans (111) inclinés par rapport à la face supérieure (2) à partir de laquelle elle s'étend en se rétrécissant jusqu'à un fond plat (24) également revêtu par la couche métallique (31), alors que l'élément opto-électronique présente une première électrode (54) d'une zone (53) du premier type de conductivité, soudée dans ledit fond plat sur la couche métallique (31) et une seconde électrode (52) d'une zone (55) du second type de conductivité, reliée électriquement à la face supérieure du substrat, caractérisé en ce que le composant comporte une deuxième cavité (26) de dimensions inférieures à celle de la première et s'étendant depuis la face inférieure du substrat jusqu'à une ouverture (25) du fond plat (24), la première et la deuxième cavités présentant à leur surface une région (30) du second type de conductivité opposé au premier, et en ce que, en vue du montage en surface du composant, la seconde électrode (52) est réliée à la face supérieure du substrat au moyen d'une première couche conductrice (35), alors que la face inférieure du substrat présente une deuxième couche conductrice (40") en contact électrique avec la région (30) du second type de conductivité et une troisième couche conductrice (40') en contact électrique avec le substrat (1).

2. Composant opto-électronique selon la revendication 1, caractérisé en ce que la deuxième couche conductrice (40") est disposée sur au moins une partie d'un prolongement (7) affleurant à la face inférieure (4) du substrat, de ladite région (30) du second type de conductivité.

3. Composant opto-électronique selon la revendication 2, caractérisé en ce que la face inférieure (4) du substrat est revêtue d'une première couche isolante (5') présentant une ouverture (15) de prise de contact débouchant sur ledit prolongement (7) et en ce que la deuxième couche conductrice (40") s'étend au moins sur ladite ouverture.

4. Composant opto-électronique selon une des revendications 1 à 3, caractérisé en ce que la face supérieure du substrat est revêtue d'une deuxième couche isolante (3') présentant au moins une fenêtre (10, 11) et en ce que la première couche conductrice (35) s'étend au moins sur ladite fenêtre, de manière à réaliser ledit contact électrique avec la face supérieure du substrat (1).

5. Composant opto-électronique selon la revendication 4 caractérisé en ce qu'une dite fenêtre (10, 11) forme une bande parallèle à un des côtés de la cavité réfléchissante (22).

6. Composant opto-électronique selon une des revendications 4 ou 5, caractérisé en ce que la première couche conductrice (35) s'étend également sur la deuxième couche isolante (3').

7. Composant opto-électronique selon une des revendications précédentes caractérisé en ce que la deuxième cavité (26) présente quatre pans disposés suivant des plans (111) inclinés par rapport à la face inférieure du substrat à partir de laquelle elle s'étend en se rétrécissant jusqu'à l'ouverture (25) du fond plat (24).

8. Composant opto-électronique selon une des revendications précédentes, caractérisé en ce qu'au moins une dite couche conductrice est métallique.

9. Procédé de fabrication de composants opto-électroniques, pour montage en surface présentant un élément opto-électronique (50) disposé au fond d'une première cavité (22) ménagée dans un support caractérisé en ce que ledit support est un substrat (1) semi-conducteur en Si fortement dopé d'un premier type de conductivité et présentant des faces supérieure (2) et inférieure (4) orientées suivant le plan (100) et en ce qu'il comporte les étapes suivantes :

a) dépôt d'une première (5') et seconde (3') couche isolante respectivement sur les faces inférieure (4) et supérieure (2) du substrat,

b) ouverture dans la seconde couche isolante (3') d'au moins une première série de premières ouvertures (20) suivant un premier réseau à deux dimensions présentant des pas donnés et correspondant auxdites premières cavités (22), et dans la première couche isolante (5') d'au moins une deuxième série de deuxièmes ouvertures (21) plus petites que les premières et à l'aplomb de celles-ci suivant un deuxième réseau à deux dimensions de mêmes pas que le premier et correspondant à des deuxièmes cavités (26),

c) réalisation des première (22) et deuxième (26) caviités par attaque sélective du substrat par une solution susceptible de creuser celui-ci selon des plans (111) inclinés par rapport au plan (100) des faces supérieure et inférieure jusqu'à ce que chaque deuxième cavité débouche par une ouverture (25) d'un fond plat (24) de la première cavité (22),

d) réalisation à partir de la surface des première et deuxième cavités de régions (30) du second type de conductivité opposé au premier,

e) dépôt d'une métallisation comportant une couche métallique (31) à la surface des cavités de manière à rendre celles-ci réfléchissantes, une couche métallique (35) en contact électrique avec la face supérieure du substrat, ainsi qu'une couche conductrice (40) sur la face inférieure du substrat présentant des premières portions (40") dont chacune est en contact électrique avec au moins une des régions (30) du second type de conductivité et des deuxièmes portions (40') en contact électrique avec le substrat au voisinage de chaque deuxième cavité,

f) réalisation de composants élémentaires mettant en oeuvre une étape de soudure d'éléments opto-électroniques (50) de telle sorte qu'ils présentent chacun une zone (53) du premier type de conductivité en contact électrique avec la couche métallique (31) d'un fond plat et une zone (55) du second type de conductivité en contact électrique avec la couche métallique (35) contactant la face supérieure du substrat, ainsi qu'une étape de découpe du substrat de manière à séparer des composants élémentaires dont chacun comporte une première et une deuxième cavité, un élément opto-électronique (50) et au moins une partie des première (40") et deuxième (40') portions de la couche conductrice (40) formant contact électrique respectivement avec une région (30) du deuxième type de conductivité et avec le substrat.

10. Procédé selon la revendication 9, caractérisé en ce que lors de l'étape f), la soudure des éléments opto-électroniques (50) a lieu avant l'étape de découpe du substrat.

11. Procédé selon une des revendications 9 ou 10 caractérisé en ce quil comporte avant l'étape b), une étape a' d'ouverture dans la première couche isolante (5') d'une première série de fenêtres (6), de diffusion à travers celle-ci de prolongements (7) des régions (30) du second type de conductivité réalisées lors de l'étape d), puis de réalisation dans ladite première série de fenêtres (6), d'une troisième couche isolante (14) d'épaisseur plus faible que celle de la première couche isolante.

12. Procédé selon une des revendications 9 à 11 caractérisé en ce qu'il comporte entre l'étape a) et l'étape b) une étape a" d'ouverture dans les première (5) et deuxième (3) couches isolantes respectivement d'une deuxième (10, 11) et une troisième (12, 15) série de fenêtres dites de contact et d'obturation de celles-ci par une quatrième couche isolante d'épaisseur plus faible que celle des deux premières couches isolantes.

13. Procédé selon la revendication 12 en combinaison avec la revendication 10 caractérisé en ce que l'étape a" a lieu après l'étape a' et en ce que l'étape de réalisation des troisième et quatrième couches isolantes est commune.

14. Procédé selon une des revendications 12 ou 13 caractérisé en ce que la couche conductrice (40) comporte des bandes (40', 40") présentant chacune une première et une deuxième portion en contact respectivement avec un nombre donné de régions du second type de conductivité et avec le substrat au voisinage d'un nombre égal de deuxième cavités et en ce que lesdites première et deuxième portions de ces bandes sont agencées de manière à correspondre à des composants élémentaires adjacents, et en ce que, lors de l'étape f, les première et deuxième portions desdites bandes sont séparées lors de la découpe.

15. Procédé selon une des revendications 11 à 14, caractérisé en ce que l'étape de dépôt des troisième et quatrième couches isolantes consiste à déposer par oxydation une couche de $SiO_2$ puis de nitrure de Si.

16. Procédé selon une des revendications 9 à 15, caractérisé en ce que ladite couche conductrice (40) est une couche métallique déposée en même temps que les autres (31, 35) couches métalliques.

**Claims**

1. An optoelectronic component comprising an optoelectronic element (50) disposed on the bottom of a first cavity (22) provided in a highly doped silicon semiconductor substrate (1) of a first conductivity type and having upper (2) and lower (4) surfaces orientated along the (100) planes, the surface of the first cavity being coated with a metallic layer (31) in such a manner that it becomes reflective and this cavity having four faces disposed along (111) planes inclined with respect to the upper surface (2) from which it extends, narrowing into a flat bottom (24) coated with the metallic layer (31), the optoelectronic element having a first electrode (54) of a zone (53) of the first conductivity type soldered at said flat bottom on the metallic layer (31) and a second electrode (52) of a zone (55) of the second conductivity type connected electrically to the upper surface of the substrate, characterized in that the component has a second cavity (26) having dimensions smaller than those of the first cavity and extending from the lower surface of the substrate to an opening (25) of said flat bottom (24), the first and second cavities having at their surfaces a region (30) of the second conductivity type opposite to the first conductivity type, and in that for surface mounting of the component, the second electrode (52) is connected to the upper surface of the substrate by means of a first conductive layer (35), while the lower surface of the substrate has a second conductive layer (40") in electrical contact with the region (30) of the second conductivity type and a third conductive layer (40') in electrical contact with the substrate (1).

2. An optoelectronic component as claimed in Claim 1, characterized in that the second conductive layer (40") is provided on at least a prolonged portion (7) of said region of the second conductivity type adjacent the lower surface (4) of the substrate.

3. An optoelectronic component as claimed in Claim 2, characterized in that the lower surface (4) of the substrate is coated with a first insulating layer (5') having a contact opening (15) on said prolonged part (7), and in that said second conductive layer (40") extends at least over said opening.

4. An optoelectronic component as claimed in any one of Claims 1 to 3, characterized in that the upper surface of the substrate is coated with a second insulating layer (3') having at least one window (10, 11) and in that said first conductive layer (35) extends at least over said window to form said electrical contact with the upper surface of the substrate (1).

5. An optoelectronic component as claimed in Claim 4, characterized in that a said window (10, 11) is strip-shaped and parallel to one side of the reflective cavity (22).

6. An optoelectronic component as claimed in any one of Claims 4 or 5, characterized in that the first conductive layer (35) extends also on the second insulating layer (3').

7. An optoelectronic component as claimed in any one of the preceding Claims, characterized in that the second cavity (26) has four faces arranged along (111) planes inclined with respect to the lower surface of the substrate, from which it extends, narrowing into the opening (25) of the flat bottom (24).

8. An optoelectronic component as claimed in any one of the preceding Claims, characterized in that at least one said conductive layer is metallic.

9. A method of manufacturing optoelectronic components for surface mounting comprising an optoelectronic element (50) arranged on the bottom of a first cavity (22) provided in a support, characterized in that the support is a highly doped semiconductor substrate (1) of silicon of a first conductivity type and having upper (2) and lower (4) surfaces orientated along the (100) planes, and in that it comprises the following steps:

a) depositing first (5') and second (3') insulating layers on the lower (4) and upper (2) surfaces, respectively, of the substrate;

b) opening at least a first series of first opening (20) in the second insulating layer (3') according to a first two-dimensional raster having a given pitch and corresponding to the first cavities (22), and at least a second series of second openings (21) in the first insulating layer (5'), which openings are smaller than the first openings and are arranged at right angles to these first openings according to a second two-dimensional raster having the same pitch as the first raster and corresponding to the second cavities (26);

c) providing the first (22) and second (26) cavities by selective etching of the substrate by a solution capable of excavating the latter according to (111) planes inclined with respect to the (100) planes of the upper and lower surfaces until each second cavity via an opening (25) in a flat bottom (24) of the first cavity (22) communicates with said first cavity;

d) forming from the surface of the first and second cavities regions (30) of the second conductivity type opposite to the first conductivity type;

e) depositing a metallization comprising a metallic layer (31) on the surface of the cavities in order to render the latter reflective and a metallic layer (35) in electrical contact with the upper surface of the substrate as well as a conductive layer (40) on the lower surface of the substrate having first portions (40"), each of which is in electrical contact with at least one of the regions (30) of the second conductivity type, and second portions (40'), each of which is in electrical contact with the substrate in the proximity of each second cavity;

f) forming elementary components by soldering opto-electronic elements (50) in such a manner that they each have a zone (53) of the first conductivity type in electrical contact with the metallic layer (31) of a flat bottom and a zone (55) of the second conductivity type in electrical contact with the metallic layer (35), which is in contact with the upper surface of the substrate, followed by cutting the substrate so as to sever elementary components, each of which comprises a first and second cavity, an optoelectronic element (50) and at least a part of the first (40") and second (40') portions of the conducting layer (40) forming an electrical contact with a region (30) of the second conductivity type and with the substrate, respectively.

10. A method as claimed in Claim 9, characterized in that during step f) the opto-electronic elements (50) are soldered before the step of cutting the substrate.

11. A method as claimed in any one of Claims 9 or 10, characterized in that before step b) a step a' is included, according to which in the first insulating layer (5') a first series of windows (6) is opened for diffusion through the latter of prolonged parts (7) of the regions (30) of the second conductivity type formed during step d), after which in said first series of windows (6) a third insulating layer (14) having a smaller thickness than that of the first insulating layer is formed.

12. A method as claimed in any one of Claims 9 to 11, characterized in that between steps a) and b) a step a" is included, according to which in the first (5) and second (3) insulating layers a second (10, 11) and a third (12, 15) series of contact windows, respectively, are opened, for contacting and obturating them through a fourth insulating layer having a smaller thickness than that of the two first insulating layers.

13. A method as claimed in Claim 10 in conjunction with Claim 12, characterized in that the step a' precedes the step a" and that the step of forming the third and fourth insulating layers is common.

14. A method as claimed in Claim 12 or 13, characterized in that the conducting layer (40) comprises strips (40', 40"), each having a first and a second portion in contact with a given number of regions of the second conductivity type and with the substrate, respectively, in the proximity of an equal number of second cavities, in that the said first and second portions of these strips are arranged so as to correspond with adjacent elementary components, and in that during step f) the first and second portions of the said strips are separated during the cutting operation.

15. A method as claimed in any one of Claims 11 to 14, characterized in that the third and fourth insulating layers are deposited by forming by oxidation a layer of silicon oxide and then of a layer of silicon nitride.

16. A method as claimed in any one of Claims 9 to 15, characterized in that said conductive layer (40) is a metallic layer deposited simultaneously with the other metallic layers (31, 35).

**Patentansprüche**

1. Optoelektronisches Bauelement mit einem auf dem Boden einer ersten Vertiefung (22) in einem hochdotierten Halbleitersubstrat (1) aus Si eines ersten Leitungstyps mit oberen (2) und unteren (4) nach der Ebene (100) orientierten Flächen vorgesehenen optoelektronischen Element (50), wobei die Oberfläche der ersten Vertiefung derart mit einer metallischen Schicht (31) bedeckt ist, daß sie reflektierend wird und wobei diese Vertiefung vier Wände gemäß den Ebenen (111) hat mit einer Schräge gegenüber der oberen Fläche (2), wobei sie sich ausgehend von derselben verjüngend bis zu einem flachen Boden (24) erstreckt, der ebenfalls mit der metallischen Schicht (31) bedeckt ist, wobei das optoelektronische Element eine erste in dem genannten flachen Boden mit der metallischen Schicht (31) verlötete Elektrode (54) einer ersten Zone (53) vom ersten Leitungstyp, sowie eine mit der oberen Fläche des Substrats elektrisch verbundene zweite Elektrode (52) einer Zone (55) vom zweiten Leitungstyp aufweist, dadurch gekennzeichnet, daß das Bauelement eine zweite Vertiefung (26) geringerer Abmessungen als die der ersten Vertiefung aufweist und die sich von der unteren Fläche des Substrats bis an eine Öffnung (25) des flachen Bodens (24) erstreckt, wobei die erste und zweite Vertiefung an ihren Oberflächen ein Gebiet (30) vom zweiten, dem ersten entgegengesetzten Leitungstyp aufweisen, und daß zur Oberflächenmontage des Bauelementes die zweite Elektrode (52) mittels einer ersten Leitungsschicht (35) mit der oberen Fläche des Substrats verbunden ist, während die untere Fläche des Substrats eine mit dem Gebiet (30) vom zweiten Leitungstyp elektrisch kontaktierte zweite Leitungsschicht (40''), sowie eine mit dem Substrat (1) elektrisch kontaktierte dritte Leitungsschicht (40') aufweist.

2. Optoelektronisches Bauelement nach Anspruch 1, dadurch gekennzeichnet, daß die zweite Leitungsschicht (40'') auf wenigstens einem Teil einer zu der unteren Fläche (4) des Substrats versenkten Verlängerung (7) des genannten Gebietes (30) vom zweiten Leitungstyp vorgesehen ist.

3. Optoelektronisches Bauelement nach Anspruch 2, dadurch gekennzeichnet, daß die untere Fläche (4) des Substrats mit einer ersten Isolierschicht (5') bedeckt ist, die eine Kontaktöffnung (15) auf der genannten Verlängerung (7) aufweist, und daß die zweite Leitungsschicht (40'') sich wenigstens über die genannte Öffnung erstreckt.

4. Optoelektronisches Bauelement nach einem der Ansprüche 1 bis 3, dadurch gekennzeichnet, daß die obere Fläche des Substrats mit einer zweiten Isolierschicht (3') versehen ist, die wenigstens ein Fenster (10, 11) aufweist, und daß die erste Leitungsschicht (35) sich wenigstens über das genannte Fenster derart erstreckt, daß der genannte elektrische Kontakt mit der oberen Fläche des Substrats (1) hergestellt wird.

5. Optoelektronisches Bauelement nach Anspruch 4, dadurch gekennzeichnet, daß ein genanntes Fenster (10, 11) einen Streifen bildet, der sich parallel zu einer der Seiten der reflektierenden Vertiefung (22) erstreckt.

6. Optoelektronisches Bauelement nach einem der Ansprüche 4 oder 5, dadurch gekennzeichnet, daß die erste Leitungsschicht (35) sich ebenfalls über die zweite Isolierschicht (3') erstreckt.

7. Optoelektronisches Bauelement nach einem der vorstehenden Ansprüche, dadurch gekennzeichnet, daß die zweite Vertiefung (26) vier Wände hat, die gemäß den Ebenen (111) vorgesehen sind und gegenüber der unteren Fläche des Substrats geneigt sind, wobei sie sich ausgehend von derselben sich verjüngend bis an die Öffnung (25) des flachen Bodens (24) erstreckt.

8. Optoelektronisches Bauelement nach einem der vorstehenden Ansprüche, dadurch gekennzeichnet, daß mindestens eine genannte Leitungsschicht metallisch ist.

9. Verfahren zum Herstellen optoelektronischer Bauelemente für Oberflächenmontage mit einem auf dem Boden einer ersten Vertiefung (22) in einem Substrat angeordneten optoelektronischen Element (50), dadurch gekennzeichnet, daß das genannte Substrat ein hochdotiertes Halbleitersubstrat (1) aus Si eines ersten Leitungstyps ist und eine gemäß der Ebene (100) orientierte obere (2) und untere Fläche (4) aufweist und daß das Verfahren die folgenden Verfahrensschritte aufweist:

a) das Niederschlagen einer ersten (5') und zweiten Isolierschicht (3') auf der unteren (4) bzw. oberen Fläche (2) des Substrats,

b) das Anbringen in der zweiten Isolierschicht (3') mindestens einer ersten Reihe erster Öffnungen (20) entsprechend einem ersten zweidimensionellen Raster mit bestimmten Teilungen und entsprechend den genannten ersten Vertiefungen, und das Anbringen in der ersten Isolierschicht (5') mindestens einer zweiten Reihe zweiter Öffnungen (21), die kleiner sind als die ersten und senkrecht zu denselben stehen entsprechend einem zweiten zweidimensionellen Raster mit denselben Teilungen wie im ersten Raster und entsprechend den zweiten Vertiefungen (26),

c) das Anbringen erster (22) und zweiter (26) Vertiefungen durch selektives Ätzen des Substrats mit einer Lösung zum Austiefen derselben entsprechend gegenüber der Ebene (100) geneigten Ebenen (111) der oberen und unteren Fläche bis jede zweite Vertiefung durch eine Öffnung (25) in dem flachen Boden (24) mit der ersten Vertiefung (22) in Verbindung steht,

d) das Anbringen, ausgehend von der Oberfläche der ersten und zweiten Vertiefung, von Gebieten (30) vom zweiten, dem ersten entgegengesetzten Leitungstyp,

e) das Niederschlagen einer Metallisierung mit einer metallischen Schicht (31) auf der Oberfläche der Vertiefungen, und zwar derart, daß sie reflektierend werden, wobei eine metallische Schicht (35) mit der oberen Fläche des Substrats in elektrischem Kontakt steht, wobei ebenfalls eine Leitungsschicht (40) auf der unteren Fläche des Substrats niedergeschlagen wird mit ersten Teilen (40''), von denen jeder mit mindestens einem der Gebiete (30) vom zweiten Leitungstyp in elektrischem Kontakt steht, und mit zweiten Teilen (40'), die in der Nähe jeder zweiten Vertiefung mit dem Substrat in elektrischem Kontakt steht,

f) das Bilden elementärer Bauteile, wobei optoelektronische Elemente (50) derart festgelötet werden, daß sie je eine Zone (53) vom ersten Leitungstyp aufweisen, die mit der metallischen Schicht (31) eines flachen Bodens in elektrischem Kontakt steht, sowie eine Zone (55) vom zweiten Leitungstyp, die mit der metallischen Schicht (35) in elektrischem Kontakt steht, wodurch die obere Fläche des Substrats kontaktiert ist, und wobei ebenfalls das Substrat derart geschnitten wird, daß einzelne elementäre Bauelemente entstehen, die je eine erste und zweite Vertiefung, ein optoelektronisches Element (50) und mindestens einen Teil erster (40'') und zweiter (40') Teile der Leitungsschicht (40) aufweisen, wodurch ein elektrischer Kontakt mit einem Gebiet (30) vom zweiten Leitungstyp bzw. mit dem Substrat hergestellt wird.

10. Verfahren nach Anspruch 9, dadurch gekennzeichnet, daß während des Verfahrensschrittes f) die optoelektronischen Elemente (50) vor dem Zerschneiden des Substrats auf demselben festgelötet werden.

11. Verfahren nach einem der Ansprüche 9 oder 10, dadurch gekennzeichnet, daß das Verfahren vor dem Verfahrensschritt b) einen Verfahrensschritt aufweist, bei dem in der ersten Isolierschicht (51) eine erste Reihe von Diffusionsfenstern (6) angebracht wird, zum durch dieselben hindurch Diffundieren von Verlängerungen (7) von Gebieten (30) vom zweiten Leitungstyp, die im Verfahrensschritt d) hergestellt werden, wonach in der ersten genannten Reihe von Fenstern (6) eine dritte Isolierschicht (14) hergestellt wird mit einer Dicke, die geringer ist als die der ersten Isolierschicht.

12. Verfahren nach einem der Ansprüche 9 bis 11, dadurch gekennzeichnet, daß es zwischen dem Verfahrensschritt a) und dem Verfahrensschritt b) einen Verfahrensschritt a'' gibt, bei dem in der ersten (5) und der zweiten (3) Isolierschicht eine zweite (10, 11) bzw. dritte Reihe von Fenstern (12, 15) hergestellt wird, wonach in den genannten Kontaktfenstern eine vierte Isolierschicht mit einer geringeren Dicke als die der zwei vorhergehenden Isolierschichten gebildet wird.

13. Verfahren nach Anspruch 12 zusammen mit Anspruch 10, dadurch gekennzeichnet, daß der Verfahrensschritt a'' nach dem Verfahrensschritt a' erfolgt, und daß die Herstellung der dritten und vierten Isolierschicht in einem gemeinsamen Verfahrensschritt erfolgt.

14. Verfahren nach einem der Ansprüche 12 oder 13, dadurch gekennzeichnet, daß die Leitungsschicht (40) Streifen (40', 40'') aufweist, die je einen ersten und einen zweiten Teil haben, der mit einer bestimmten Anzahl Gebiete vom zweiten Leitungstyp bzw. dem Substrat in der Nähe einer gleichen Anzahl zweiter Vertiefungen verbunden ist, und daß der genannte erste und zweite Teil dieser Streifen derart angeordnet sind, daß sie benachbarten elementären Bauteilen entsprechen, und daß während des Verfahrensschrittes f der erste und zweite Teil der genannten Streifen beim Zerschneiden voneinander getrennt werden.

15. Verfahren nach einem der Ansprüche 11 bis 14, dadurch gekennzeichnet, daß die dritte und vierte Isolierschicht dadurch angebracht werden, daß zunächst eine SiO$_2$-Schicht und danach eine Siliciumnitridschicht durch oxidiert wird.

16. Verfahren nach einem der Ansprüche 9 bis 15, dadurch gekennzeichnet, daß die genannte Leitungsschicht (40) eine gleichzeitig mit den anderen metallischen Schichten (31, 35) niedergeschlagene metallische Schicht ist.

EP 0 221 616 B1

FIG.1a

FIG.1b

FIG.1c

FIG.1d

FIG.1e

EP 0 221 616 B1

FIG.1f

FIG.1g

FIG.1h

FIG.2a

FIG.2b

FIG.3